# EUROPEAN PATENT SPECIFICATION

(11) **EP 4 387 067 B1**
(45) Date of publication and mention of the grant of the patent: **27.05.2026**
(21) Application number: 22855184.2
(22) Date of filing: 19.07.2022
(51) Int. Cl.: H02M 1/088

(54) **DRIVING APPARATUS AND ELECTRONIC DEVICE**
ANTRIEBSVORRICHTUNG UND ELEKTRONISCHE VORRICHTUNG
APPAREIL D'ATTAQUE ET DISPOSITIF ÉLECTRONIQUE

(30) Priority: 13.08.2021 CN 202110929027
(43) Date of publication of application: 19.06.2024
(73) Proprietor: ZTE Corporation, Shenzhen, Guangdong 518057 (CN)
(72) Inventor: SHI, Linran, Shenzhen, Guangdong 518057 (CN); TU, Darui, Shenzhen, Guangdong 518057 (CN); ZHOU, Jianping, Shenzhen, Guangdong 518057 (CN); ZHOU, Wei, Shenzhen, Guangdong 518057 (CN); WANG, Wenbing, Shenzhen, Guangdong 518057 (CN); LI, Runchao, Shenzhen, Guangdong 518057 (CN)
(74) Representative: Savi, Massimiliano
(86) International application number: PCT/CN2022/106486
(87) International publication number: WO 2023/016201

(56) References cited:
- CN-A- 101 478 243
- CN-A- 107 733 236
- CN-A- 110 190 732
- CN-A- 112 514 222
- US-A- 4 454 430
- US-A- 4 728 809
- US-A- 5 763 962
- US-A1- 2010 052 768
- US-B1- 9 966 837
- US-B2- 7 573 730
- US-B2- 8 040 161

## Description

### TECHNICAL FIELD

The present disclosure relates to the technical field of electronics, and in particular to a driving device, and an electronic apparatus.

### BACKGROUND

In some cases, the driving device usually outputs a high-level driving signal to the power electronic device to turn on the power electronic device. Generally, the duration during which the power electronic device is turned on, is consistent with the duration of the high-level signal. The power electronic device is turned on upon receiving a rising edge of the high-level signal and is turned off upon receiving a falling edge of the high-level signal. This driving scheme requires more energy to maintain the continuous turn-on state of power electronic devices, which will cause greater driving loss. Furthermore, the driving device is generally driven by a transformer with a large volume, resulting in a large overall volume of the driving device.

US8040161B2 is directed to drive circuit device for a power semiconductor, and signal transfer circuit device for use therein.

US4454430A proposes high voltage FET's (field effect transistors) that are used to modulate a traveling wave tube, which makes it possible to achieve fast rise, fall and delay characteristics, and very long pulse widths to CW because of their low drive requirements to maintain the on condition.

US 2010/052768 A1 provides a means and method for preventing unwanted semiconductor turn-on and turn-off, caused by a high rate of voltage change, without significantly affecting the desired ON and OFF transitions of the semiconductor.

US 5763962 A proposes a high-voltage semiconductor driving circuit to be instantaneously operated for the duration of an arbitrary pulse width can be effectuated through an extremely simple circuit configuration.

### SUMMARY

The following is a summary of the subject matter described herein. This summary is not intended to limit the scope of protection of the claims.

The invention is set out in the appended claims.

Provided are a driving device, and an electronic apparatus in some embodiments of the present disclosure.

### BRIEF DESCRIPTION OF DRAWINGS

The drawings are intended to provide a further understanding of the technical scheme of the present disclosure, and constitute a part of the specification, and they are intended to illustrate the technical scheme of the present disclosure in conjunction with the embodiments of the present disclosure, but are not intended to limit the technical scheme of the present disclosure.
FIG. 1 depicts a schematic diagram of the waveform relationship between a turn-on signal and a driving signal of a power electronic device in some cases;
FIG. 2 depicts a schematic diagram of a driving device according to an embodiment of the present disclosure;
FIG. 3 depicts a schematic diagram showing a waveform relationship among a turn-on signal of the power electronic device, a first edge control signal and a second edge control signal according to an embodiment of the present disclosure;
FIG 4. depicts a schematic diagram showing a circuit of a driving device according to an embodiment of the present disclosure;
FIG. 5 depicts a schematic diagram of another driving device according to an embodiment of the present disclosure;
FIG. 6 depicts a schematic diagram showing a waveform relationship among a turn-on signal of the power electronic device, a first edge control signal and a second edge control signal according to an embodiment of the present disclosure;
FIG. 7 depicts a schematic diagram of another driving device according to an embodiment of the present disclosure;
FIG. 8 depicts a schematic diagram of another driving device according to an embodiment of the present disclosure;
FIG. 9 depicts a schematic diagram of another driving device according to an embodiment of the present disclosure;
FIG. 10 depicts a schematic diagram showing a waveform relationship among a turn-on signal of the power electronic device, a first edge control signal and a second edge control signal according to an embodiment of the present disclosure;
FIG. 11 depicts a schematic diagram of another driving device according to an embodiment of the present disclosure; and
FIG. 12 is a schematic diagram of a waveform relationship between a turn-on signal of the power electronic device, a first edge control signal and a second edge control signal according to an embodiment of the present disclosure.

### DETAILED DESCRIPTION

The purpose, technical scheme, and advantages of the present disclosure will become apparent through the following description for various embodiments in conjunction with the drawings. It should be understood that the embodiments described here are intended for illustration but not limitation to the present disclosure.

It shall be understood that, in the description of an embodiment of the present disclosure, the terms "first" and "second" if described, are intended for distinguishing technical features, which shall not be understood as indicating or implying relative importance or implicitly indicating the number of the indicated technical features or the order of the indicated technical features. "At least one" means one or more, and "multiple" means two or more. Connection "and/or" describes the relationship of related objects, indicating that there can be three kinds of relationships. For example, A and/or B, which can indicate the situation that A alone, both A and B, or B alone. A and B can be singular or plural. The character "/"generally indicates that the context object is in an "OR" relationship. "At least one of the following" and similar expressions refer to any combination of these items, including any combination of single or plural items. For example, at least one of A, B, and C can indicate: A, B, C, both A and B, both A and C, both B and C, or A and B and C, where A, B and C can be single or plural.

It shall be understood by those having ordinary skills in the art that the connections described in an embodiment of the present disclosure include direct connections, and indirect connections connected through intermediate components.

In addition, the technical features involved in various embodiments of the present disclosure described below can be combined with each other as long as they do not conflict with each other.

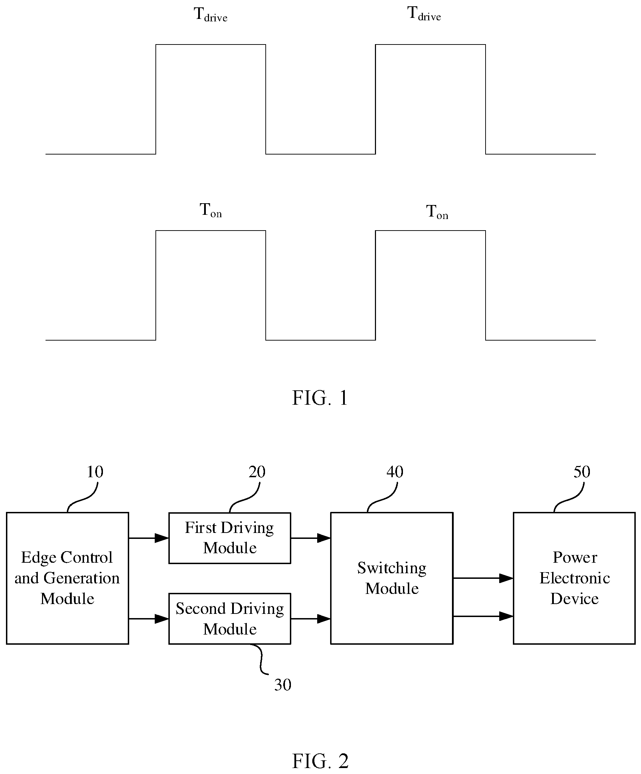

In some cases, in order to drive a power electronic device, a driving transformer typically provides a high-level signal for the power electronic device to activate the same. Referring to FIG. 1, the duration Tₒₙ during which the power electronic device is turned on, is consistent with the high-level signal duration T_{drive}. The power electronic device is turned on upon receiving a rising edge of the high-level signal and is turned off upon receiving a falling edge of the high-level signal.

This driving scheme needs more energy to maintain the turning-on state of the power electronic device, and will cause greater driving loss. Generally, the volume of the driving transformer to realize this driving scheme is usually large, and it is usually necessary to arrange a DC blocking capacitor in the primary winding of the driving transformer to prevent the driving transformer from saturation. Besides, under dynamic operating conditions such as when the driving duty ratio is changed, the driving level will change with the duty ratio due to the limitation of the volt second principle of the transformer. As a result, this common driving scheme for power electronic devices is not suitable for occasions that require significant adjustment of the duty cycle.

In view of this, there is provided a driving device and an electronic apparatus in some embodiments of the present disclosure, in which it is not necessary to output a long-duration high-level signal to maintain the turning-on state of power electronic devices, such that the driving loss and the volume of the driving device are reduced.

FIG. 2 depicts a schematic diagram showing a driving device according to an embodiment of the present disclosure. As shown in FIG. 2, the driving device includes an edge control and generation module 10, a first driving module 20, a second driving module 30, and a switching module 40. The input ends of the first driving module 20 and the second driving module 30 are respectively connected with the edge control and generation module 10, and the output ends of the first driving module 20 and the second driving module 30 are respectively connected with the switching module 40.

It can be understood that, in an embodiment of the present disclosure, the edge control and generation module 10 is configured to output a first edge control signal and a second edge control signal at intervals. In an embodiment, the edge control and generation module 10 can alternately output the first edge control signal and the second edge control signal through two output ends. That is, the first output end outputs the first edge control signal and the second output end outputs the second edge control signal, and the two output ends output the edge control signals at different times. The output time interval of the first edge control signal and the second edge control signal can be preset.

In an implementation, the high-level durations of the first edge control signal and the second edge control signal can be set to nanosecond (ns) level, such as within 100ns. Alternatively, the duration can also be set to greater than 100ns, and the present disclosure is not limited thereto.

The edge control and generation module 10 of an embodiment of the present disclosure can be specifically implemented as an ARM chip, a DSP, or another digital control chip.

It can be understood that, in an embodiment of the present disclosure, the first driving module 20 is configured to receive the first edge control signal from the edge control and generation module 10 and to output at least one first edge driving signal according to the first edge control signal. The second driving module 30 is configured to receive the second edge control signal from the edge control and generation module 10 and to output at least one second edge driving signal according to the second edge control signal. In this way, the first driving module 20 and the second driving module 30 alternately output edge driving signals to the switching module 40.

It can be understood that a plurality of switching modules 40 may be provided in an embodiment of the present disclosure. Each switching module 40 is configured to receive a first edge driving signal from the first driving module 20 and a second edge driving signal from the second driving module 30, and to turn on or turn off the power electronic device 50 according to the first edge driving signal and the second edge driving signal.

In some embodiments, after the switching module 40 receives the first edge driving signal from the first driving module 20, the turn-on state of the power electronic device 50 is kept. And after the switching module 40 receives the second edge driving signal from the second driving module 30, the power electronic device 50 is turned off. In this way, the turning-on and turning-off of the power electronic device 50 are controlled by two successive edge driving signals.

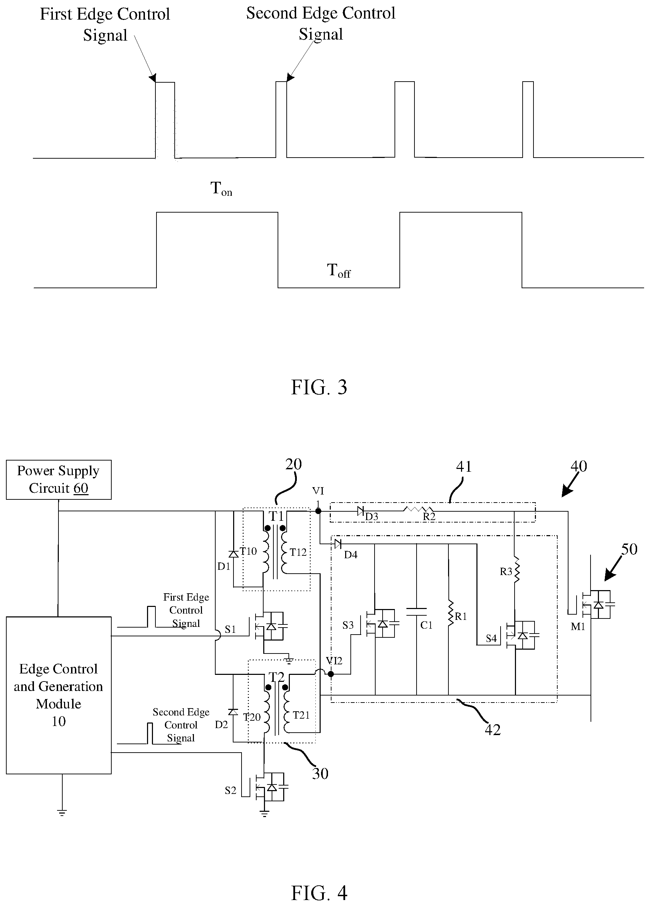

FIG. 3 depicts a schematic diagram showing a waveform relationship among the turn-on signal of the power electronic device 50, the first edge control signal and the second edge control signal according to an embodiment of the present disclosure. In FIG. 3, Tₒₙ denotes the time during which the power electronic device is activated, and T_{off} denotes the time during which the power electronic device is deactivated. As shown in FIG. 3, Tₒₙ of the power electronic device 50 is determined by the time interval between the moment at which a first edge driving signal is received and the moment at which a second edge driving signal is received.

In an embodiment, the edge control and generation module 10 outputs the first edge control signal and the second edge control signal at intervals. The first driving module 20 is controlled to output the first edge driving signal to the switching module 40 by the first edge control signal, and the second driving module 30 is controlled to output the second edge driving signal to the switching module 40 by the second edge control signal. So that the switching module 40 turns on and turns off the power electronic device 50 under the control of the first edge driving signal and the second edge driving signal. The duration during which the power electronic device 50 is turned on is the temporal interval between the rising edge of the first edge driving signal and the rising edge of the second edge driving signal. Thereby, the power electronic device 50 can be turned on or turned off according to the first edge driving signal and the second edge driving signal. According to an embodiment of the present disclosure, it is not necessary to provide a continuously high-level signal for maintaining the activation of the power electronic device 50, thus the energy required for maintaining the consecutive activation of the power electronic device 50 is less, and the driving loss is low, which is beneficial to reducing the volume of the driving device.

The driving device provided by the present disclosure will be further described in detail through some embodiments.

### EMBODIMENT ONE

FIG. 4 depicts a schematic diagram showing a circuit of a driving device according to an embodiment of the present disclosure.

As shown in FIG. 4, the first driving module 20 includes a first driving transformer T1 that includes a first primary winding T10 and a first secondary winding T11. The first primary winding T10 is connected to the edge control and generation module 10, and is configured to receive a first edge control signal from the edge control and generation module 10. The first secondary winding T11 is connected to the switching module 40, and is configured to output a first edge driving signal to the corresponding switching module 40 according to the first edge control signal after sensing the first edge control signal from the first primary winding T10.

It can be understood that, in an embodiment, the driving device further includes a power supply circuit 60. The power supply circuit 60 has a plurality of voltage output ends each respectively connected with the dotted end of the first primary winding T10 and the edge control and generation module 10, so as to provide operating voltages for the first driving transformer T1 and the edge control and generation module 10.

In some embodiments, a third switching tube S1 and a third diode D1 are included between the edge control and generation module 10 and the first driving transformer T1. The gate electrode of the third switching tube S1 is connected to the first output end of the edge control and generation module 10, the anode of the third diode D1 is connected to the drain electrode of the third switching tube S1, and the cathode of the third diode D1 is connected to the dotted end of the first primary winding T10.

It can be understood that when the edge control and generation module 10 outputs the first edge control signal to the third switching tube S1, the third switching tube S1 is activated. The third switching tube S1 applies a voltage between the power supply circuit 60 and the reference ground to both ends of the first primary winding T10. After sensing the edge voltage corresponding to the first edge control signal from the first primary winding T10, the first secondary winding T11 outputs a first edge driving signal to the corresponding switching module 40.

As shown in FIG. 4, the second driving module 30 includes a second driving transformer T2 that includes a second primary winding T20 and a second secondary winding T21. The second primary winding T20 is connected to the edge control and generation module 10, and is configured to receive a second edge control signal from the edge control and generation module 10. The second secondary winding T21 is connected to the switching module 40, and is configured to output a second edge driving signal to the corresponding switching module 40 according to the second edge control signal after sensing the second edge control signal from the second primary winding T20.

It can be understood that the voltage output end of the power supply circuit 60 is further connected to the dotted end of the second primary winding T20, thereby providing the operating voltage for the second driving transformer T2.

In some embodiments, a fourth switching tube S2 and a fourth diode D2 are included between the edge control and generation module 10 and the second driving transformer T2. The gate electrode of the fourth switching tube S2 is connected to the second output end of the edge control and generation module 10, the anode of the fourth diode D2 is connected to the drain electrode of the fourth switching tube S2, and the cathode of the fourth diode D2 is connected to the dotted end of the second primary winding T20.

It can be understood that when the edge control and generation module 10 outputs the second edge control signal to the fourth switching tube S2, the fourth switching tube S2 is activated. The fourth switching tube S2 applies a voltage between the power supply circuit 60 and the reference ground to both ends of the second primary winding T20. After sensing the edge voltage corresponding to the second edge control signal from the second primary winding T20, the second secondary winding T21 outputs a second edge driving signal to the corresponding switching module 40.

It should be understood that the third diode D1 can be a reset diode, which provides a discharge loop for the first driving transformer T1 after the first edge control signal disappears and the third switching tube S1 is deactivated. Similarly, the fourth diode D2 can be a reset diode, which provides a discharge loop for the second driving transformer T2 after the second edge control signal disappears and the fourth switching tube S2 is deactivated.

It can be understood that the edge control and generation module of an embodiment of the present disclosure includes an edge control and generation chip (ARM chip, DSP, or another digital control chip) for outputting a first edge control signal and a second edge control signal at intervals.

In an embodiment, the edge control and generation module further includes a first driving capability enhancement circuit. When the edge control and generation chip outputs a first edge control signal to the first driving capability enhancement circuit, the first driving capability enhancement circuit enhances the first edge control signal and outputs the processed first edge control signal to the gate electrode of the third switching tube S1.

In an embodiment, the edge control and generation module further includes a second driving capability enhancement circuit. When the edge control and generation chip outputs a second edge control signal to the second driving capability enhancement circuit, the second driving capability enhancement circuit enhances the second edge control signal and outputs the processed second edge control signal to the gate electrode of the fourth switching tube S2.

It should be understood that the power supply circuit 60 is connected with and thus provides operating voltages to the edge control and generation chip, the first driving capability enhancement circuit and the second driving capability enhancement circuit respectively.

In some embodiments, each of the first driving capability enhancement circuit and the second driving capability enhancement circuit is an AND gate circuit or a push-pull circuit. Alternatively, each of the first driving capability enhancement circuit and the second driving capability enhancement circuit can also be another means, circuit, or device that can be configured to enhance driving ability. It should also be understood that the first driving capability enhancement circuit and the second driving capability enhancement circuit may be the same or different circuit types. For example, the first driving capability enhancement circuit is an AND gate circuit and the second driving capability enhancement circuit is a push-pull circuit. The circuit structures of the first driving capability enhancement circuit and the second driving capability enhancement circuit are not specifically limited herein.

It can be understood that in an embodiment of the present disclosure, in order to enhance the driving ability of the edge control signal output by the edge control and generation chip (an ARM chip, a DSP, or another digital control chip), and ensure that the third switching tube S1 and the fourth switching tube S2 can be reliably turned on, primary driving ability enhancement circuits are respectively arranged between the edge control and generation chip and the third switching tube S1 and between the edge control and generation chip and the fourth switching tube S2 to enhance the driving ability. The first edge control signal output by the edge control and generation chip is enhanced by the first driving capability enhancement circuit and then output to the third switching tube S1 to reliably activate the third switching tube S1. The second edge control signal output by the edge control and generation chip is enhanced by the second driving capability enhancement circuit and then output to the fourth switching tube S2, so as to reliably activate the fourth switching tube S2.

As shown in FIG. 4, according to an embodiment, the switching module 40 includes a turn-on loop 41 and a turn-off loop 42.

The turn-on loop 41 includes a first diode D3 and a first driving input end VI1. The anode of the first diode D3 is connected to the first driving input end VI1, and the cathode of the first diode D3 is connected to the power electronic device M1.

The turn-off loop 42 includes a first switching tube S3, a second switching tube S4, and a second driving input end VI2. The gate electrode of the first switching tube S3 is connected to the second driving input end VI2. The drain electrode of the first switching tube S3 is connected to the gate electrode of the second switching tube S4. The drain electrode of the second switching tube S4 is connected to the power electronic device M1.

In an example, the first driving input end VI1 is configured to receive a first edge driving signal from the first driving module 20. The second driving input end VI2 is configured to receive a second edge driving signal from the second driving module 30.

In an example, the first driving input end VI1 is configured to receive a second edge driving signal from the second driving module 30. The second driving input end VI2 is configured to receive a first edge driving signal from the first driving module 20. The power electronic device 50 as shown in FIG. 4, includes a power electronic device M1, which can be a MOSFET switching tube, for example. Alternatively, another voltage-driven power electronic device can also be applied to the basic circuit topology of the driving device according to an embodiment of the present disclosure. In the following, an embodiment of the present disclosure is illustrated by way of an example where the power electronic device is provided as a MOSFET switching tube.

As shown in FIG. 4, the gate electrode of the power electronic device M1 is connected to the cathode of the first diode D3. The source electrode of the power electronic device M1 is connected to both the source electrode of the first switching tube S3 and the drain electrode of the second switching tube S4.

It should be noted that the first driving input end VI1 and the second driving input end VI2 are configured for a one-to-one corresponding connection with the first driving module 20 and the second driving module 30. That is, the first driving input end VI1 is connected to the first driving module 20, and the second driving input end VI2 is connected to the second driving module 30.

As shown in FIG. 4, the first driving input end VI1 of the turn-on loop 41 is connected to the dotted end of the first secondary winding T11 to receive a first edge driving signal from the first secondary winding T11. The second driving input end VI2 of the turn-off loop 42 is connected to the dotted end of the second secondary winding T21 to receive a second edge driving signal from the second secondary winding T21.

As an example, the first switching tube S3 is an NMOS tube and the second switching tube S4 is a PMOS tube. Alternatively, the first switching tube S3 and the second switching tube S4 can also be triodes or other devices with similar functions, and the present disclosure is not limited thereto.

The operating principle of the switching module 40 will be described below in conjunction with FIG. 4.

The turn-on process of the switching module 40 is as follows. After receiving the first edge driving signal output by the first secondary winding T11, the first driving input end VI1 of the turn-on loop 41 transmits the first edge driving signal to the gate electrode of the power electronic device M1 through the first diode D3, such that the power electronic device M1 is turned on and the power electronic device is turned on. The unilateral conductivity of the first diode D3 enables the grid capacitance of the power electronic device M1 to continue to be maintained at a high-level voltage that activates the power electronic device M1, after the first edge driving signal disappears, without the reverse discharge of the grid capacitance of the power electronic device M1, thus allowing the duration of the first edge control signal applied to the first primary winding T10 of the first driving transformer T1 to be greatly shortened. The duration of the first edge control signal may be 20ns-100ns, or may be greater than 100ns.

The turn-off process of the switching module 40 is as follows. After receiving the second edge driving signal output by the second secondary winding T21, the second driving input end VI2 of the turn-off loop 42 transmits the second edge driving signal to the gate electrode of the first switching tube S3, such that the first switching tube S3 is turned on, and in turn the second edge driving signal is transmitted to the second switching tube S4. Then the second switching tube S4 is turned on, thus providing a discharge loop for the power electronic device M1. Thereby, the power electronic device M1 is deactivated and turned off.

See FIG. 3 for the waveform relationship between the turn-on signal of the power electronic device M1, the first edge control signal, and the second edge control signal in the driving device shown in FIG. 4.

In an embodiment, as shown in FIG. 4, the turn-on loop 41 further includes a first resistor R2 connected between the cathode of the first diode D3 and the power electronic device M1. The first resistor R2 is configured to limit the gate electrode charging current of the power electronic device M1, so as to limit the current during the turn-on process, to reduce EMI.

In some embodiments, as shown in FIG. 4, the turn-off loop 42 may further include a second resistor R3 connected between the source electrode of the second switching tube S4 and the power electronic device M1. The second resistor R3 is configured to limit the turn-off speed of the power electronic device M1, which acts to limit the current during the turn-off process, and to reduce EMI.

In an embodiment, as shown in FIG. 4, the turn-off loop 42 further includes a second diode D4 and an RC loop. The RC loop is connected between the drain electrode and the source electrode of the first switching tube S3. The anode of the second diode D4 is connected to the first driving input end VI1, and the cathode of the second diode D4 is connected to the RC loop.

In an embodiment, the RC loop includes a third resistor R1, and a first capacitor C1 in a parallel connection.

It can be understood that based on the RC loop, the turn-off loop 42 according to an embodiment of the present disclosure further provides a fault protection mechanism to realize the automatic deactivation of the power electronic devices. The operating principle of the fault protection mechanism is as follows.

When the first edge driving signal comes, the existence of the first resistor R2 enables the gate electrode level of the PMOS-type second switching tube S4 greater than its source electrode level. The second switching tube S4 is always in the deactivated state during the activation of the power electronic device M1. On the premise that the activation voltage drop of the second diode D4 is neglected, the first capacitor C1 is charged to the voltage across the first secondary winding T11 through the second diode D4. Since the unilateral conductivity of the second diode D4 and the second edge control signal has not yet arrived, the first switching tube S3 is deactivated, and the first capacitor C1 will be discharged through the third resistor R1. Because the selected resistance value of R1 is relatively large, and the time constant of RC charge-discharge combination formed by R1 and C1 is relatively large, the second switching tube S4 is always in the turned-off state before a normal second edge control signal comes, that is, the gate electrode-source electrode voltage of the power electronic device M1 is kept at a high level and the power electronic device M1 is kept turned on. When a normal second edge control signal comes, the first switching tube S3 is turned on, and provides a small resistance discharge loop for the first capacitor C1, such that the gate electrode level of the second switching tube S4 is lower than the source electrode level, and the second switching tube S4 starts to turn on, clamping the voltage at both ends of the gate electrode and source electrode of the power electronic device M1 at a voltage value lower than the gate electrode turn-on voltage. The gate electrode and source electrode voltages of the power electronic device M1 are rapidly discharged through the second resistor R3 and the second switching tube S4, thus realizing the normal and rapid turn-off of the power electronic device M1. In case of the absence of the second edge control signal and the subsequent first edge control signal, the voltage across the first capacitor C1 will slowly discharge through the third resistor R1 until the gate electrode level of the second switching tube S4 is lower than the source electrode level at a moment, the second switching tube S4 is turned-on, and the gate electrode-source electrode voltages of the power electronic device M1 begins to drop, thus realizing self-turn-off.

It should be understood that the time constant of the R1C1 combination selected in an embodiment of the present disclosure can be set as within 3 times the typical switching period of the power electronic device M1, and can also be regulated accordingly according to the practical application scenario.

It should be noted that the second driving transformer T2 does not need to provide energy to charge the gate electrode capacitance of the power electronic device M1 like the first driving transformer T1, so the second driving transformer T2 can be provided as another isolating-type signal transmission device as an alternative, such as an optocoupler.

It can be understood that when the example in FIG. 4 is implemented, the duration of the second edge control signal may be lower than that of the first edge control signal. For example, the duration of the first edge control signal is 100ns, and the duration of the second edge control signal is 20-50ns. Alternatively, the duration of the second edge control signal may be the same as that of the first edge control signal.

It should be understood that the third switching tube S1 and the fourth switching tube S2 described in an embodiment of the present disclosure can be any fully controlled switching tube.

### EMBODIMENT TWO

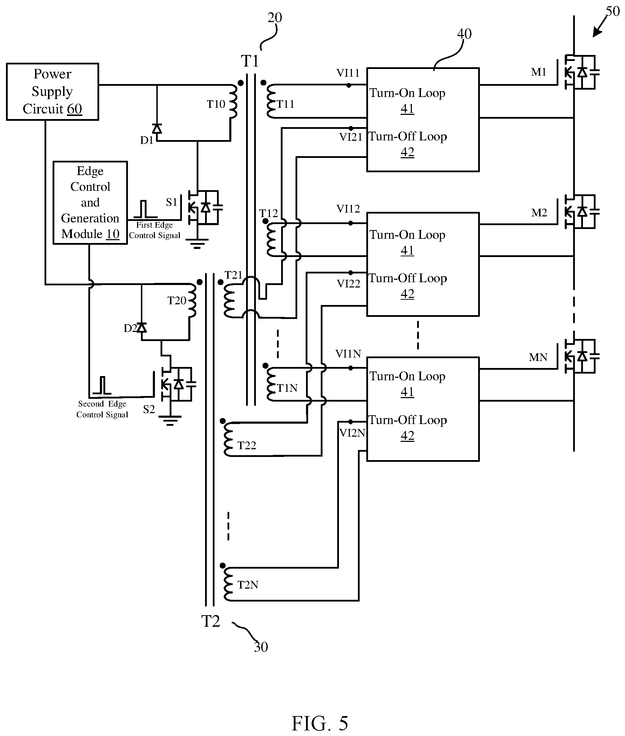

FIG. 5 depicts a schematic diagram showing a circuit of another driving device according to an embodiment of the present disclosure.

In some specific situations, such as where the cost and the common voltage level of power electronic devices (such as MOSFET) are considered, it is necessary to employ the technology where power electronic devices are connected in series (such as high voltage occasions) to reduce the cost or improve the withstand voltage. However, the driving scheme of series-connected MOSFETs still has room for improvement in the industry. Because MOSFET devices do not have the characteristic of automatic voltage sharing, the slight difference in internal parameters of devices will result in a serious imbalance between the drain electrode and source electrode voltages of series-connected power electronic devices during switching. Especially in series-connected power electronic devices, devices with a slow turn-on process or fast turn-off process will bear higher voltage, which will lead to overvoltage breakdown in serious cases. The dynamic voltage imbalance of power electronic devices when they are connected in series is mainly determined by the inconsistency of external driving signals and the discreteness of the devices themselves.

According to an embodiment of the present disclosure, there is provided an edge isolation driving scheme. Under this scheme, the energy required for driving the transformers to maintain the continuous turn-on state of the power electronic devices is less, and the driving loss is less. Accordingly, the transformer is correspondingly small in size and has fewer winding turns, thus reducing the influence of parasitic parameters such as leakage inductance, and the driving consistency of the outputs of multichannel of the secondary windings is good, which can ensure the switching speed consistency of multichannel and in-series driving, and the above issue is addressed.

The driving device shown in FIG. 5 provides a scheme for driving N(N≥2) series-connected power electronic devices.

As shown in FIG. 5, the first driving module 20 includes a first driving transformer T1 including a first primary winding T10 and N first secondary windings (T11, T12, ..., T1N). The second driving module 30 includes a second driving transformer T2 including a second primary winding T20 and N second secondary windings (T21, T22,..., T2N).

It can be understood that the first driving transformer T1 and the second driving transformer T2 in FIG. 5 are provided as multi-winding transformers by way of an example. The in-series driving method in which N single-winding transformers are provided instead of one multi-winding transformer (with N identical secondary windings) is also within the scope of the present disclosure.

As shown in FIG. 5, the switching modules 40 are provided in the number of N. Each switching module 40 includes a turn-on loop 41 and a turn-off loop 42. Each of the N turn-on loops 41 is connected to a respective one of the N first secondary windings, and each of the N turn-off loops 42 is connected to a respective one of the N second secondary windings. In FIG. 5, VI11, VI12, ..., VI1N correspondingly denote the first driving input ends of N turn-on loops 41, and VI21, VI22, ..., VI2N correspondingly denote the second driving input ends of N turn-off loops 42.

It can be understood that the distribution of windings in FIG. 5 and the connection sequence with the switching modules 40 are not limited by those shown in the figure. Any connection that can realize the driving of N(N≥2) series-connected power electronic devices is within the scope of the present disclosure.

In FIG. 5, the power electronic device 50 includes a combination of series connected power electronic devices ΣMi (i=1, 2, ..., N, where N≥2). Each of the N power electronic devices Mi is connected to a respective one of the N switching modules 40.

It should be understood that, as shown in FIG. 5, each switching module 40 is identical to the switching module 40 shown in FIG. 4 in terms of the circuit topology, and the details are not repeated here.

The operating principle of the driving device shown in FIG. 5 is as follows. The edge control and generation module 10 outputs a first edge control signal to the gate electrode of the third switching tube S1, such that the third switching tube S1 is turned on, and applies the voltage between the power supply circuit and the reference ground to both ends of the first primary winding T10 of the first driving transformer T1. The N first secondary windings (T11, T12, ..., T1N) of the first driving transformer T1 respectively induce one edge voltage corresponding to the first edge control signal from the first primary winding T10, and output N first edge driving signals each acting on the turn-on loop 41 corresponding to a respective one of the power electronic device Mi (i=1, 2, ..., N) for turning on the combination of the power electronic device Mi (i=1, 2, ..., N). The edge control and generation module 10 outputs a second edge control signal to the gate electrode of the fourth switching tube S2, such that the fourth switching tube S2 is turned on, and applies the voltage between the power supply circuit and the reference ground to both ends of the second primary winding T20 of the second driving transformer T2. The N second secondary windings (T21, T22, ..., T2N) of the second driving transformer T2 respectively induce one edge voltage corresponding to the second edge control signal from the second primary winding T20, and output N second edge driving signals each acting on the turn-off loop 42 corresponding to a respective one of the power electronic device Mi (i=1, 2, ..., N) for turning off the combination of the power electronic device Mi (i=1, 2, ..., N). The operating process of turning on and off a single power electronic device Mi (i=1, 2, ..., N) has been described in detail in Embodiment One, and will not be repeated here.

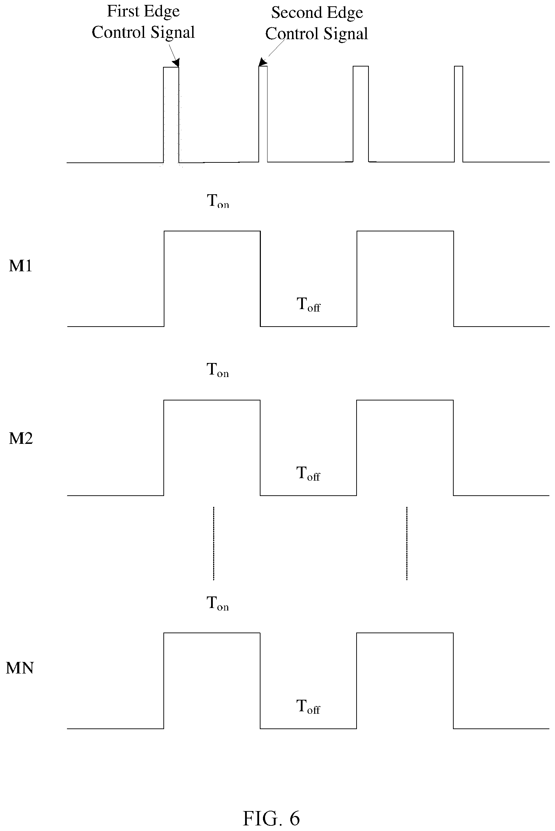

See FIG. 6 for the waveform relationship between the turn-on signal of each power electronic device Mi (i=1, 2, ..., N), the first edge control signal, and the second edge control signal shown in FIG. 5. In FIG. 6, Tₒₙ denotes the time during which the power electronic device is activated, and T_{off} denotes the time during which the power electronic device is deactivated. As shown in FIG. 6, Tₒₙ of each power electronic device Mi (i= 1, 2, ..., N) is determined by the temporal interval between the moment at which a first edge driving signal is received and the moment at which a second edge driving signal is received.

In an embodiment of the in-series driving scheme of power electronic devices described in Embodiment Two, devices with the same functions in the circuit topology of the driving device are integrated into one package to obtain better in-series driving consistency. For example, the first diodes D3 in the N turn-on loops 41 are integrated into one package. The second diodes D4 in the N turn-off loops 42 are integrated into one package. The first switching tubes S3 in the N turn-off loops 42 are integrated in one package. Alternatively, the PMOS-type second switching tubes S4 in the N turn-off loops 42 are integrated into one package.

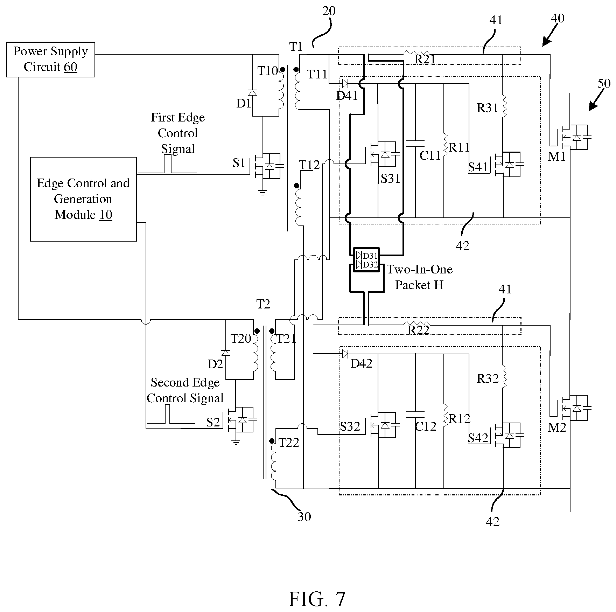

FIG. 7 shows a circuit of a driving device configured for in-series driving of two power electronic devices. As shown in FIG. 7, the first diodes (D31, D32) in two turn-on loops 41 are integrated into one package part H.

In the scheme of in-series driven integrated devices shown in FIG. 7, when the first secondary windings T11 and T12 of the first driving transformer T1 are connected to the turn-on loop 41 for driving the power electronic devices M1 and M2, each of the dotted end of the first secondary winding T11 and the dotted end of the first secondary winding T12 of the first driving transformer T1 is respectively connected to one of the two input ends of the two-in-one package H. Two first diodes D31 and D32 are integrated in the two-in-one package H. Each of the two output ends of the two-in-one package H is respectively connected to one end of one of two first resistors R21 and R22. It should be noted that the device connection inside the turn-on loop 41/ turn-off loop 42 and the turn-on and turn-off process of a single power electronic device Mi have been described in detail in Embodiment One, and will not be described here.

It should also be noted that the embodiment described in FIG. 7 is illustrated with respect to the diode D3 in the turn-on loop by way of an example, and shows an integrated device scheme for realizing in-series driving in Embodiment Two. The scheme for in-series driving integrated devices based on the basic circuit topology of edge driving isolation described in Embodiment One described in an embodiment of the present disclosure includes, but is not limited to, integrating the diodes D3 in N(N≥2) turn-on loops into one package, integrating the diodes D4 in N(N≥2) turn-off loops into one package, integrating the switching tubes S3 in N(N≥2) turn-off loops into one package and integrating the PMOS-type field effect switching tubes S4 in N(N≥2) turn-off loops into one package, or integrating any selected devices into one package, are all within the scope of the present disclosure. Embodiment 2 of the present disclosure is based on the in-serial driving of the integrated devices of the edge-driven isolated basic circuit topology described in Embodiment 1, and is not limited to the package of a specific type of integrated devices, and any package that can integrate N devices with the same function is within the scope of the present disclosure.

The content and scope of Embodiment 1 in the present disclosure are applicable to Embodiment 2, and all other embodiments obtained by those having ordinary skills in the art without devoting creative labor are within the scope of the present disclosure.

It should be understood that when the in-series driving scheme of power electronic devices described in Embodiment 2 is realized, besides the integrated device scheme, the scheme of discrete devices can also be adopted.

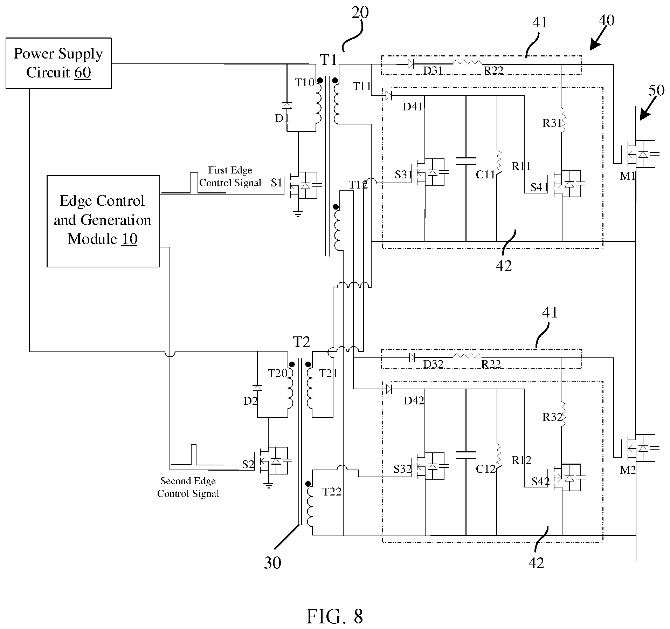

For example, shown in FIG. 8 is a driving device for in-series driving of power electronic devices by adopting a discrete-device scheme, which is different from the embodiment shown in FIG. 7 in that, in the embodiment shown in FIG. 8, devices with the same function between two turn-on loops 41 are packaged independently, and similarly, devices with the same function between two turn-off loops 42 are also packaged independently.

It should be noted that the embodiments described in FIGS. 5 to 8 are only a part of an embodiment of the present disclosure, not the whole embodiment 2. For example, the in-series driving method in which N single-winding transformers are provided instead of one multi-winding transformer (with N identical secondary windings) is also within the scope of the present disclosure. The distribution of windings in FIG. 5, FIG. 7 and FIG. 8 and the connection sequence with the driving circuits are not limited to those shown, and any connection that can realize the in-series driving of N(N≥2) power electronic devices is within the scope of the present disclosure. The in-series driving method described in Embodiment 2 based on the edge isolation driving topology described in Embodiment 1 has a discrete device scheme in addition to the integrated device scheme. The content and scope of Embodiment 1 in the present disclosure are applicable to Embodiment 2, and all other embodiments obtained by those having ordinary skills in the art without devoting creative labor are within the scope of the present disclosure.

### EMBODIMENT THREE

In the basic circuit topology adopted by the driving device according to an embodiment of the present disclosure, the turn-on and turn-off of the power electronic device M1 are controlled by two driving modules respectively, and such feature in structure and function makes it suitable for complementary driving occasions, such as applications like half-bridge and full-bridge applications. On this basis, in an embodiment of the present disclosure, a complementary driving scheme is provided on the basis of the basic circuit topology described in Embodiment 1.

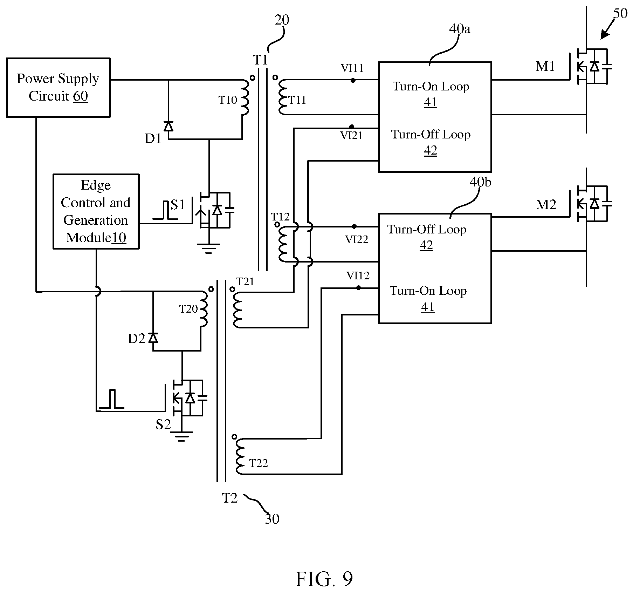

FIG. 9 depicts a schematic diagram showing a circuit of another driving device according to an embodiment of the present disclosure.

In the driving device shown in FIG. 9, the switching module 40 includes a first switching module 40a and a second switching module 40b. Both the first switching module 40a and the second switching module 40b include the turn-on loop and the turn-off loop as described above. The first driving input end VI11 of the first switching module 40a is connected to the first driving module 20. The second driving input end VI21 of the first switching module 40a is connected to the second driving module 30. The first driving input end VI12 of the second switching module 40b is connected to the second driving module 30. The second driving input end VI22 of the second switching module 40b is connected to the first driving module 20. The first switching module 40a is connected with a power electronic device M1. The second switching module 40b is connected with a power electronic device M2.

The circuit topologies of the turn-on loop and the turn-off loop of the first switching module 40a and the second switching module 40b in FIG. 9 are the same as those of the turn-on loop and the turn-off loop shown in FIG. 4, and are not repeated here.

It can be understood that the first driving module 20 includes a first driving transformer T1 including a first primary winding T10 and at least two first secondary windings (T11, T12,..). The second driving module 30 includes a second driving transformer T2 including a second primary winding T20 and at least two second secondary windings (T21, T22,..).

In an embodiment, as shown in FIG. 9, for the first switching module 40a, the first driving input end VI11 of its turn-on loop is connected with the first secondary winding T11, and the second driving input end VI21 of its turn-off loop is connected with the second secondary winding T21. For the second switching module 40b, the first driving input end VI12 of its turn-on loop is connected with the second secondary winding T22, and the second driving input end VI22 of its turn-off loop is connected with the first secondary winding T12. The first switching module 40a is correspondingly connected to the power electronic device M1. The second switching module 40b is correspondingly connected to the power electronic device M2.

The driving device shown in FIG. 9 can realize the logical function of the XOR gate of the digital circuit (also called "XOR" driving technology). The operating process of the turn-on loop and turn-off loop of a single power electronic device Mi (i=1, 2) has been described in detail in Embodiment One, and will not be repeated here.

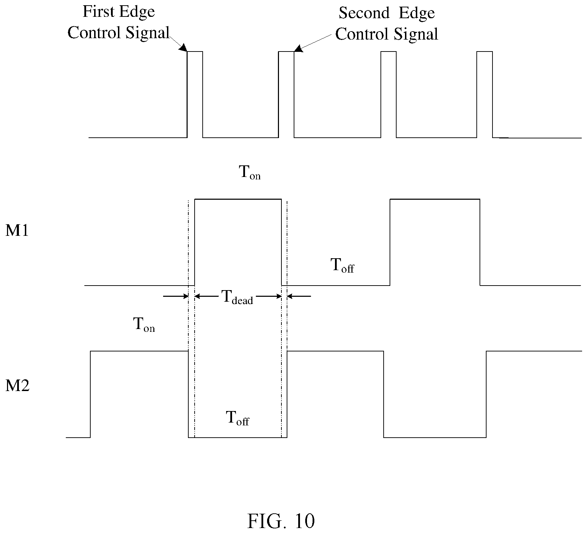

When the edge control and generation module 10 alternately outputs the first edge control signal and the second edge control signal at intervals, the waveform relationship between the turn-on signal of the power electronic device M1 and the power electronic device M2, the first edge control signal, and the second edge control signal as shown in FIG. 9, is shown in FIG. 10. In FIG. 10, Tₒₙ denotes the time during which the power electronic device is activated, and T_{off} denotes the time during which the power electronic device is deactivated. As can be seen from FIG. 10, the turn-on signal of power electronic devices M1 and M2 have a complementary waveform relationship, that is, when M1 is turned on, M2 is turned off; and when M1 is turned off, M2 is turned on.

The dead time (T_{dead}) between the turn-on signals of M1 and M2 can be regulated by the first resistor R2 and the second resistor R3 in FIG. 4. An additional resistor can be connected in series between the dotted ends of the secondary windings of the driving transformers T1 and T2 and the anode of the first diode D3 of the turn-on loop 41 of each power electronic device to adjust the dead time.

The operating principle of the driving device shown in FIG. 9 is as follows.

The edge control and generation module 10 outputs a first edge control signal to the gate electrode of the third switching tube S1, such that the third switching tube S1 is turned on, and applies the voltage between the power supply circuit and the reference ground to both ends of the first primary winding T10 of the first driving transformer T1. The two first secondary windings T11 and T12 of T1 respectively induce edge voltages corresponding to the first edge control signal from the first primary winding T10 and output first edge driving signals. The first edge driving signal output by T11 acts on the turn-on loop 41 of the power electronic device M1 to turn M1 on. The first edge driving signal output by T12 acts on the turn-off loop 42 of the power electronic device M2 to turn M2 off. Here, the first edge control signal output by the edge control and generation module 10 has a dual function that can simultaneously turn M1 on and turn M2 off.

The edge control and generation module 10 outputs a second edge control signal to the gate electrode of the fourth switching tube S2, such that the fourth switching tube S2 is turned on, and applies the voltage between the power supply circuit and the reference ground to both ends of the second primary winding T20 of the second driving transformer T2. Both second secondary windings T21, and T22 of the second driving transformer T2 respectively induce edge voltages corresponding to the second edge control signal from the second primary winding T20 and respectively output second edge driving signals. The second edge driving signal output by T21 acts on the turn-off loop 42 of the power electronic devices M1 to turn off the power electronic device M1. The second edge driving signal output by T22 acts on the turn-on loop 41 of the power electronic device M2, to turn on the power electronic device M2. Here, the second edge control signal output by the edge control and generation module 10 has a dual function that can simultaneously turn M2 on and turn M1 off.

The third diode D1 as shown in FIG. 9 can be a reset diode, which provides a discharge loop for the first driving transformer T1 after the first edge control signal disappears and the third switching tube S1 is deactivated. Similarly, the fourth diode D2 can be a reset diode, which provides a discharge loop for the second driving transformer T2 after the second edge control signal disappears and the fourth switching tube S2 is deactivated. Based on the third diode D1 and the fourth diode D2, the circuit of the driving device will be reset, so that M1 and M2 are not turned on.

It should be noted that the embodiment described in FIG. 9 is only a part of an embodiment of the present disclosure, not the whole embodiment 3. A multi-winding transformer is shown in FIG. 9 by way of an example, and the complementary driving method in which two single-winding transformers are provided instead of one multi-winding transformer (with two identical secondary windings) is also within the scope of the present disclosure. The source electrode of M1 in FIG. 9 and the drain electrode of M2 may or may not be connected with each other. The distribution of windings in FIG. 9 and the connection sequence with the driving circuits are not limited to those shown in the figure, and any connection mode that can realize the complementary driving of two power electronic devices falls within the scope of the present disclosure. The content and scope of Embodiment 1 in the present disclosure are applicable to Embodiment 3, and all other embodiments obtained by those having ordinary skills in the art without devoting creative labor are within the scope of the present disclosure.

### EMBODIMENT FOUR

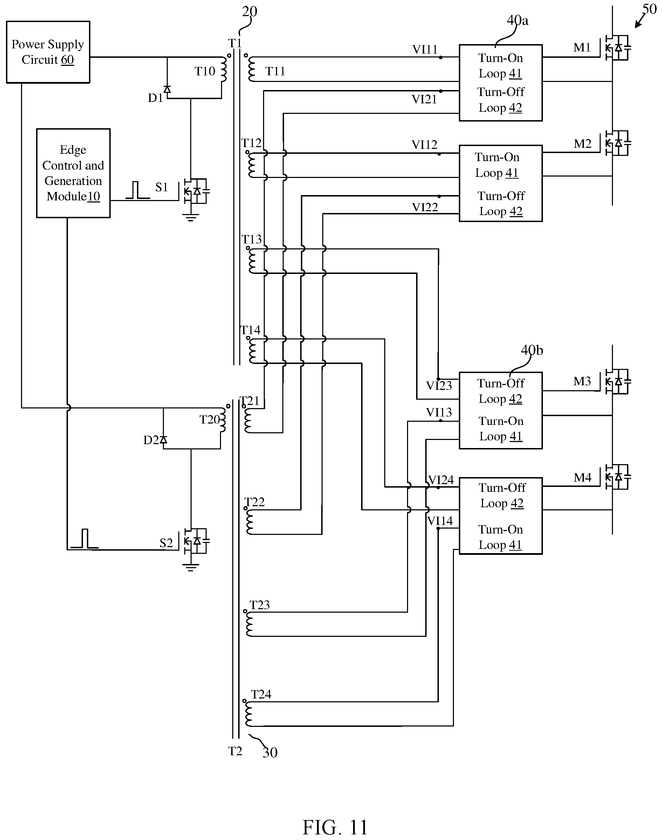

FIG. 11 depicts a schematic diagram showing a circuit of another driving device according to an embodiment of the present disclosure.

In the driving device shown in FIG. 11, the switching module 40 includes a plurality of first switching modules 40a and a plurality of second switching modules 40b. A first driving input end of each of the first switching modules 40a is connected to the first driving module 20 respectively. A second driving input end of each of the first switching modules 40a is connected to the second driving module 30 respectively. A first driving input end of each of the second switching modules 40b is connected to the second driving module 30 respectively. A second driving input end of each of the second switching modules 40b is connected to the first driving module 20 respectively.

The circuit topologies of the turn-on loop and the turn-off loop of the first switching module 40a and the second switching module 40b in FIG. 11 are the same as those of the turn-on loop and the turn-off loop shown in FIG. 4, and are not repeated here.

The driving device shown in FIG. 11 includes a first combination of power electronic devices and a second combination of power electronic devices each respectively including at least two power electronic devices connected in series. For example, the first combination of the power electronic devices includes power electronic devices M1 and M2, and the second combination of power electronic devices includes power electronic devices M3 and M4. Power electronic devices M1 and M2 in the first combination of power electronic devices are connected to a first switching module 40a respectively. The power electronic devices M3 and M4 in the second combination of power electronic devices are connected to a second switching module 40b respectively.

In an embodiment, as shown in FIG. 11, the first driving module 20 includes a first driving transformer T1 including a first primary winding T10 and a plurality of first secondary windings (T11, T12, T13, T14). The second driving module 30 includes a second driving transformer T2 including a second primary winding T20 and a plurality of second secondary windings (T21, T22, T23, T24). The first driving input ends VI11 and VI12 of the turn-on loops 41 of the two first switching modules 40a are connected to the first secondary windings T11 and T12, respectively. The second driving input ends VI21 and VI22 of the turn-off loops 42 of the two first switching modules 40a are connected to the second secondary windings T21 and T22, respectively. The first driving input ends VI13 and VI14 of the turn-on loops 41 of the two second switching modules 40b are connected to the second secondary windings T23 and T24, respectively. The second driving input ends VI23 and VI24 of the turn-off loops 42 of the two second switching modules 40b are connected to the first secondary windings T13 and T14.

The operating principle of the driving device shown in FIG. 11 is as follows.

The edge control and generation module 10 outputs one first edge control signal to the gate electrode of the third switching tube S1, such that the third switching tube S1 is turned on, and applies the voltage between the power supply circuit and the reference ground to both ends of the first primary winding T10 of the first driving transformer T1. The first secondary windings T11, T12, T13, and T14 of T1 respectively induce edge voltages corresponding to the first edge control signal from the first primary winding T10 and output first edge driving signals. The first edge driving signals output by T11 and T12 act on the turn-on loops 41 of the power electronic devices M1 and M2 to turn M1 and M2 on. The first edge driving signals output by T13 and T14 act on the turn-off loops 42 of the power electronic devices M3 and M4 to turn M3 and M4 off. Here, the first edge control signal output by the edge control and generation module 10 has a dual function that can simultaneously turn M1 and M2 on and turn M3 and M4 off.

The edge control and generation module 10 outputs a second edge control signal to the gate electrode of the fourth switching tube S2, such that the fourth switching tube S2 is turned on, and applies the voltage between the power supply circuit and the reference ground to both ends of the second primary winding T20 of the second driving transformer T2. The second secondary windings T21, T22, T23, and T24 of the second driving transformer T2 respectively induce edge voltages corresponding to the second edge control signal from the second primary winding T20 and respectively output second edge driving signals. The second edge driving signals output by T21 and T22 act on the turn-off loops 42 of the power electronic devices M1 and M2 to turn off the power electronic devices M1 and M2. The second edge driving signals output by T23 and T24 act on the turn-on loops 41 of the power electronic devices M3 and M4, to turn on the power electronic devices M3 and M4. Here, the second edge control signal output by the edge control and generation module 10 has a dual function that can simultaneously turn M3 and M4 on and turn M1 and M2 off.

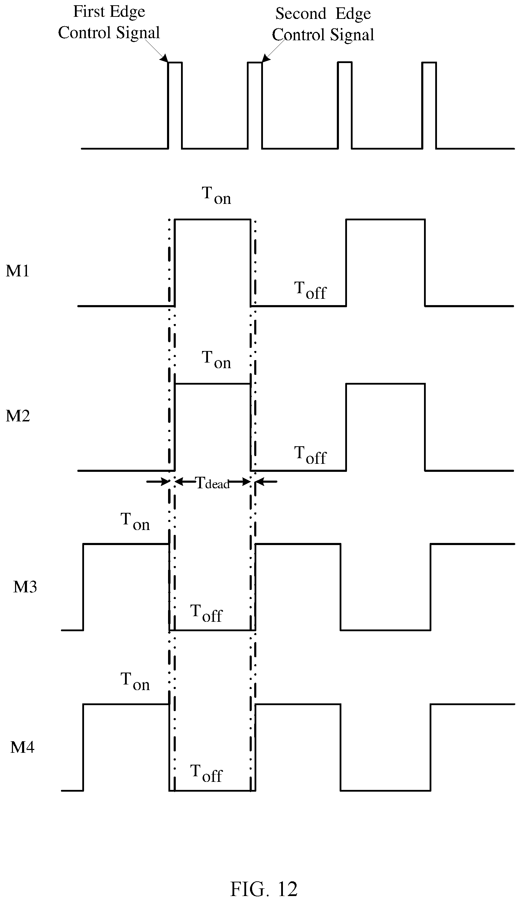

See FIG. 12 for the waveform relationship between the turn-on signal of the power electronic devices M1, M2, M3, and M4, the first edge control signal, and the second edge control signal shown in FIG. 11. The dead time (T_{dead}) between M1+M2 in-series driving combination and M3+M4 in-series driving combination is adjusted by the first resistor R2 and the second resistor R3 in FIG. 4. An additional resistor can be connected in series between the dotted ends of the secondary windings of the driving transformers T1 and T2 and the anode of the first diode D3 of the turn-on loop 41 of each power electronic device to adjust the dead time.

The third diode D1 as shown in FIG. 11 can be a reset diode, which provides a discharge loop for the first driving transformer T1 after the first edge control signal disappears and the third switching tube S1 is deactivated. Similarly, the fourth diode D2 can be a reset diode, which provides a discharge loop for the second driving transformer T2 after the second edge control signal disappears and the fourth switching tube S2 is deactivated. Based on the third diode D1 and the fourth diode D2, the circuit of the driving device will be reset, so that M1, M2, M3, and M4 are not turned on.

It can be understood that the scheme of Embodiment Four integrates the in-series driving function of Embodiment Two and the complementary driving function of Embodiment THREE.

It should be noted that the embodiment described in FIG. 11 is only a part of the embodiment of the present disclosure, but not the whole embodiment 4. For example, in FIG. 11, the driving of four power electronic devices is illustrated by way of an example. The function integration method described in Embodiment 4 of the present disclosure includes but is not limited to the driving of four power electronic devices, and the driving of 2N(N≥2) power electronic devices is also applicable (each set of N devices is in the in-series driving relationship, and a combination of N device in-series driven devices is in a complementary driving relationship with another combination of N device in-series driven devices). Each of the first/second edge driving transformers T1 and T2 described in Embodiment 4 of the present disclosure has 2N secondary windings, and N secondary windings are respectively connected with the turn-on loops of a combination of N in-series driven devices, and the remaining N secondary windings are respectively connected with the turn-off loops of another combination of N in-series driven devices. The distribution of windings in FIG. 11 and the connection sequence with the driving circuits are not limited to those shown, and any connection that can realize the driving of the integration of 2N(N≥2) power electronic devices by the driving method is within the scope of the present disclosure. The source electrode of M2 and the drain electrode of M3 in FIG. 11 of the attached drawings may or may not be connected with each other. The source electrode of the last one of the N in-series driving devices and the drain electrode of the first one of another N in-series driving devices may or may not be connected with each other in the present disclosure of functional integrated driving of 2N(N≥2) power electronic devices. The contents and scopes of Embodiments 1 to 3 in the present disclosure are applicable to Embodiment 4, and all other embodiments obtained by those having ordinary skills in the art without devoting creative effort are within the scope of the present disclosure.

It should be noted that Embodiments 3 and 4 described in the present disclosure involve complementary driving, and the duration of the two first/second edge control signals sent by the edge control and generation circuit are identical. However, the duration of the first edge control signal and the second edge control signal in the in-series driving method described in Embodiment 2 and the basic circuit topology of edge isolation driving described in Embodiment 1 can be the same or different. Generally, the duration of the first edge control signal is longer than that of the second edge control signal.

In the edge isolation driving method described in an embodiment of the present disclosure, the duration of the edge control signal utilized to turn on/off the power electronic device Mi (i=1, 2, ..., N) is within the order of nanoseconds, and the energy transmitted by the driving transformer is less. As a result, the first driving transformer T1, and the second driving transformer T2 described in Embodiments One to Four can be provided as transformers having small volumes, such as wound transformers and PCB planar transformers. It should be understood that any type of transformer (such as traditional wound transformers) that can realize the function of the edge isolation driving circuit in the present disclosure is within the scope of the present disclosure.

It shall be noted that, in the above-described embodiments, the description of each embodiment focuses on a respective aspect. Those portions that are not detailed or recited in one embodiment, can be referred to the relevant descriptions of other embodiments.

According to an embodiment of the present disclosure, there is provided an electronic apparatus, which includes the driving device described in any of the above embodiments.

According to the electronic apparatus set forth in an embodiment of the present disclosure, the edge control and generation module 10 outputs the first edge control signal and the second edge control signal at intervals. The first driving module 20 is controlled to output the first edge driving signal to the switching module 40 by the first edge control signal, and the second driving module 30 is controlled to output the second edge driving signal to the switching module 40 by the second edge control signal. So that the switching module 40 turns on and turns off the power electronic device 50 under the control of the first edge driving signal and the second edge driving signal. The power electronic device is kept turned on during the temporal interval between the rising edge of the first edge driving signal and the rising edge of the second edge driving signal. Thereby, the power electronic device can be turned on or turned off according to the first edge driving signal and the second edge driving signal. According to an embodiment of the present disclosure, it is not necessary to provide a continuously high-level signal for maintaining the activation of the power electronic device 50, thus the energy required for maintaining the consecutive activation of the power electronic device is less, and the driving loss is low, which is beneficial to reducing the volume of the driving device.

**In** an embodiment, the edge control and generation module outputs the first edge control signal and the second edge control signal at intervals. The first driving module is controlled to output the first edge driving signal to the switching module by the first edge control signal, and the second driving module is controlled to output the second edge driving signal to the switching module by the second edge control signal. So that the switching module turns on and turns off the power electronic device under the control of the first edge driving signal and the second edge driving signal. The power electronic device is kept turned on during the temporal interval between the rising edge of the first edge driving signal and the rising edge of the second edge driving signal. Thereby, the power electronic device can be turned on or turned off according to the first edge driving signal and the second edge driving signal. According to an embodiment of the present disclosure, it is not necessary to provide a continuously high-level signal for maintaining the activation of the power electronic device, thus the energy required for maintaining the consecutive activation of the power electronic device is less, and the driving loss is low, which is beneficial to reducing the volume of the driving device.

## Claims

1. A driving device, comprising,
an edge control and generation module (10), configured to alternatively output a first edge control signal, and a second edge control signal;
a first driving module (20), configured to receive the first edge control signal from the edge control and generation module (10) and to output at least one first edge driving signal according to the first edge control signal;
a second driving module (30), configured to receive the second edge control signal from the edge control and generation module (10) and output at least one second edge driving signal according to the second edge control signal; and
at least one switching module (40), configured to receive the first edge driving signal from the first driving module (20) and the second edge driving signal from the second driving module (30), and to turn on or turn off a power electronic device (M1) according to the first edge driving signal and the second edge driving signal;
wherein at least one turn-on loop (41) and at least one turn-off loop (42) are provided, and each of the at least one switching module (40) comprises a respective one of the at least one turn-on loop (41) and a respective one of the at least one turn-off loop (42);
the turn-on loop (41) comprises a first diode (D3) and a first driving input end (VI1), an anode of the first diode (D3) is connected to the first driving input end (VI1), and a cathode of the first diode (D3) is connected to a gate electrode of the power electronic device (M1);
the turn-off loop (42) comprises a first switching tube (S3), a second switching tube (S4), and a second driving input end (VI2); a gate electrode of the first switching tube (S3) is connected to the second driving input end (VI2); a drain electrode of the first switching tube (S3) is connected to the gate electrode of the second switching tube (S4); the source electrode of the second switching tube (S4) is connected to the gate of the power electronic device (M1);
and the drain electrode of the second switching tube (S4) is connected to a source electrode of the power electronic device (M1); and
the first driving input end (VI1) is configured to receive the first edge driving signal from the first driving module (20), and the second driving input end (VI2) is configured to receive the second edge driving signal from the second driving module (30); or, the first driving input end (VI1) is configured to receive the second edge driving signal from the second driving module (30), and the second driving input end (VI2) is configured to receive the first edge driving signal from the first driving module (20);
the driving device being **characterized in that**
the turn-off loop (42) further comprises a second diode (D4) and an RC loop; the RC loop is connected between the drain electrode and the source electrode of the first switching tube (S3); the anode of the second diode (D4) is connected to the first driving input end (VI1), and the cathode of the second diode (D4) is connected to the RC loop.

2. The driving device as claimed in claim 1, wherein the turn-on loop (41) further comprises a first resistor (R2) connected between the cathode of the first diode (D3), and the power electronic device (M1); and
the turn-off loop (42) further comprises a second resistor (R3) connected between a source electrode of the second switching tube (S4), and the power electronic device (M1).

3. The driving device as claimed in claim 1 or 2, wherein the at least one turn-on loop (41) comprises two turn-on loops (41), and the at least one turn-off loop (42) comprises two turn-off loops (42); the switching module (40) comprises a first switching module (40a) and a second switching module (40b), and each of the first switching module (40a) and the second switching module (40b) comprises a respective one of the two turn-on loops (41) and a respective one of the two turn-off loops (42);
the first driving input end (VI1) of the first switching module (40a) is connected to the first driving module (20), and the second driving input end (VI2) of the first switching module (40a) is connected to the second driving module (30); and
the first driving input end (VI1) of the second switching module (40b) is connected to the second driving module (30), and the second driving input end (VI2) of the second switching module (40b) is connected to the first driving module (20).

4. The driving device as claimed in claim 1, wherein the first driving module (20) comprises a first driving transformer (T1) comprising a first primary winding (T10) and at least one first secondary winding, the first primary winding (T10) is configured to receive the first edge control signal from the edge control and generation module (10), and each of the first secondary windings is configured to output one first edge driving signal according to the first edge control signal.

5. The driving device as claimed in claim 4, wherein a third switching tube (S1) and a third diode (D1) are arranged between the edge control and generation module (10) and the first driving transformer (T1), the gate electrode of the third switching tube (S1) is connected to a first output end of the edge control and generation module (10), the anode of the third diode (D1) is connected to the drain electrode of the third switching tube (S1), and the cathode of the third diode (D1) is connected to a dotted end of the first primary winding (T10).

6. The driving device as claimed in claim 5, wherein the edge control and generation module (10) comprises an edge control and generation chip and a first driving capability enhancement circuit;
wherein the first driving capability enhancement circuit comprises an AND gate circuit or a push-pull circuit;
the edge control and generation chip is configured to output the first edge control signal to the first driving capability enhancement circuit; and
the first driving capability enhancement circuit is configured to process the first edge control signal and to output the processed first edge control signal to the gate electrode of the third switching tube (S1).

7. The driving device as claimed in claim 1, wherein the second driving module (30) comprises a second driving transformer (T2) comprising a second primary winding (T20) and at least one second secondary winding, the second primary winding (T20) is configured to receive the second edge control signal from the edge control and generation module (10), and each of the second secondary windings is configured to output one second edge driving signal according to the second edge control signal.

8. The driving device as claimed in claim 7, wherein a fourth switching tube (S2) and a fourth diode (D2) are arranged between the edge control and generation module (10) and the second driving transformer (T2), the gate electrode of the fourth switching tube (S2) is connected to a second output end of the edge control and generation module (10), the anode of the fourth diode (D2) is connected to the drain electrode of the fourth switching tube (S2), and the cathode of the fourth diode (D2) is connected to a dotted end of the second primary winding (T20).

9. The driving device as claimed in claim 8, wherein the edge control and generation module (10) comprises an edge control and generation chip and a second driving capability enhancement circuit;
wherein the second driving capability enhancement circuit comprises an AND gate circuit or a push-pull circuit;
the edge control and generation chip is configured to output the second edge control signal to the second driving capability enhancement circuit; and
the second driving capability enhancement circuit is configured to process the second edge control signal and to output the processed second edge control signal to the gate electrode of the fourth switching tube (S2).

10. A driving device, for driving a plurality of power electronic devices connected in series, the driving device comprising,
an edge control and generation module (10), configured to alternatively output a first edge control signal, and a second edge control signal;
a first driving module (20), configured to receive the first edge control signal and comprising a first driving transformer (T1) that comprises a first primary winding (T10) and N first secondary windings;
a second driving module (30), configured to receive the second edge control signal and comprising a second driving transformer (T2) that comprises a second primary winding (T20) and N second secondary windings; and
a plurality of switching modules (40) provided in a number of N; wherein each of the switching modules (40) comprises a turn-on loop (41) connected to a respective one of the N first secondary windings, and a turn-off loop (42) connected to a respective one of the N second secondary windings;
wherein the turn-on loop (41) comprises a first diode (D3) and a first driving input end (VI1), an anode of the first diode (D3) being connected to the first driving input end (VI1), and a cathode of the first diode (D3) being connected to a gate electrode of the power electronic device (M1);
wherein the turn-off loop (42) comprises a first switching tube (S3), a second switching tube (S4), and a second driving input end (VI2); a gate electrode of the first switching tube (S3) being connected to the second driving input end (VI2); a drain electrode of the first switching tube (S3) being connected to the gate electrode of the second switching tube (S4); the source electrode of the second switching tube (S4) being connected to the gate of the power electronic device (M1); and the drain electrode of the second switching tube (S4) being connected to a source electrode of the power electronic device (M1); and
wherein the first driving input end (VI1) is connected to a respective one of the N first secondary windings and the second driving input end (VI2) is connected to a respective one of the N second secondary windings;
wherein the turn-off loop (42) further comprises a second diode (D4) and an RC loop; the RC loop being connected between the drain electrode and the source electrode of the first switching tube (S3); the anode of the second diode (D4) being connected to the first driving input end (VI1), and the cathode of the second diode (D4) being connected to the RC loop;
wherein, each of the power electronic devices is connected to a respective one of switching modules (40).

11. The driving device as claimed in claim 10, wherein a third switching tube (S1) and a third diode (D1) are arranged between the edge control and generation module (10) and the first driving transformer (T1), a gate electrode of the third switching tube (S1) is connected to a first output end of the edge control and generation module (10), an anode of the third diode (D1) is connected to a drain electrode of the third switching tube (S1), and a cathode of the third diode (D1) is connected to a dotted end of a first primary winding (T10) of the first secondary windings.

12. The driving device as claimed in claim 11, wherein a fourth switching tube (S2) and a fourth diode (D2) are arranged between the edge control and generation module (10) and the second driving transformer (T2), the gate electrode of the fourth switching tube (S2) is connected to a second output end of the edge control and generation module (10), the anode of the fourth diode (D2) is connected to the drain electrode of the fourth switching tube (S2), and the cathode of the fourth diode (D2) is connected to a dotted end of a second primary winding (T20) of the second secondary windings.

13. An electronic apparatus, comprising the driving device as claimed in any one of claims 1 to 9, or the driving device as claimed in any one of claims 10 to 12.

## Patentansprüche

1. Antriebsvorrichtung, umfassend
ein Flankensteuerungs- und -erzeugungsmodul (10), das dazu konfiguriert ist, abwechselnd ein erstes Flankensteuerungssignal und ein zweites Flankensteuerungssignal auszugeben;
ein erstes Antriebsmodul (20), das dazu konfiguriert ist, das erste Flankensteuerungssignal von dem Flankensteuerungs- und -erzeugungsmodul (10) zu empfangen und mindestens ein erstes Flankenantriebssignal entsprechend dem ersten Flankensteuerungssignal auszugeben;
ein zweites Antriebsmodul (30), das dazu konfiguriert ist, das zweite Flankensteuerungssignal von dem Flankensteuerungs- und -erzeugungsmodul (10) zu empfangen und mindestens ein zweites Flankenantriebssignal entsprechend dem zweiten Flankensteuerungssignal auszugeben; und
mindestens ein Schaltmodul (40), das dazu konfiguriert ist, das erste Flankenantriebssignal von dem ersten Antriebsmodul (20) und das zweite Flankenantriebssignal von dem zweiten Antriebsmodul (30) zu empfangen und eine elektronische Leistungsvorrichtung (M1) entsprechend dem ersten Flankenantriebssignal und dem zweiten Flankenantriebssignal einzuschalten oder auszuschalten;
wobei mindestens eine Einschaltschleife (41) und mindestens eine Ausschaltschleife (42) vorgesehen sind und jedes des mindestens einen Schaltmoduls (40) eine jeweilige der mindestens einen Einschaltschleife (41) und eine jeweilige der mindestens einen Ausschaltschleife (42) umfasst;
die Einschaltschleife (41) eine erste Diode (D3) und ein erstes Antriebs-Eingangsende (VI1) umfasst, wobei eine Anode der ersten Diode (D3) mit dem ersten Antriebs-Eingangsende (VI1) verbunden ist und eine Kathode der ersten Diode (D3) mit einer Gate-Elektrode der elektronischen Leistungsvorrichtung (M1) verbunden ist;
die Ausschaltschleife (42) eine erste Schaltröhre (S3), eine zweite Schaltröhre (S4) und ein zweites Antriebs-Eingangsende (VI2) umfasst; eine Gate-Elektrode der ersten Schaltröhre (S3) mit dem zweiten Antriebs-Eingangsende (VI2) verbunden ist; eine Drain-Elektrode der ersten Schaltröhre (S3) mit der Gate-Elektrode der zweiten Schaltröhre (S4) verbunden ist; die Source-Elektrode der zweiten Schaltröhre (S4) mit dem Gate der elektronischen Leistungsvorrichtung (M1) verbunden ist;
und die Drain-Elektrode der zweiten Schaltröhre (S4) mit einer Source-Elektrode der elektronischen Leistungsvorrichtung (M1) verbunden ist; und
das erste Antriebs-Eingangsende (VI1) dazu konfiguriert ist, das erste Flankenantriebssignal von dem ersten Antriebsmodul (20) zu empfangen, und das zweite Antriebs-Eingangsende (VI2) dazu konfiguriert ist, das zweite Flankenantriebssignal von dem zweiten Antriebsmodul (30) zu empfangen; oder das erste Antriebs-Eingangsende (VI1) dazu konfiguriert ist, das zweite Flankenantriebssignal von dem zweiten Antriebsmodul (30) zu empfangen, und das zweite Antriebs-Eingangsende (VI2) dazu konfiguriert ist, das erste Flankenantriebssignal von dem ersten Antriebsmodul (20) zu empfangen;
wobei die Antriebsvorrichtung **dadurch gekennzeichnet ist, dass**
die Ausschaltschleife (42) ferner eine zweite Diode (D4) und eine RC-Schleife umfasst; die RC-Schleife zwischen der Drain-Elektrode und der Source-Elektrode der ersten Schaltröhre (S3) verbunden ist; die Anode der zweiten Diode (D4) mit dem ersten Antriebs-Eingangsende (VI1) verbunden ist und die Kathode der zweiten Diode (D4) mit der RC-Schleife verbunden ist.

2. Antriebsvorrichtung nach Anspruch 1, wobei die Einschaltschleife (41) ferner einen ersten Widerstand (R2) umfasst, der zwischen der Kathode der ersten Diode (D3) und der elektronischen Leistungsvorrichtung (M1) verbunden ist; und die Ausschaltschleife (42) ferner einen zweiten Widerstand (R3) umfasst, der zwischen einer Source-Elektrode der zweiten Schaltröhre (S4) und der elektronischen Leistungsvorrichtung (M1) verbunden ist.

3. Antriebsvorrichtung nach Anspruch 1 oder 2, wobei die mindestens eine Einschaltschleife (41) zwei Einschaltschleifen (41) umfasst und die mindestens eine Ausschaltschleife (42) zwei Ausschaltschleifen (42) umfasst; das Schaltmodul (40) ein erstes Schaltmodul (40a) und ein zweites Schaltmodul (40b) umfasst, und jedes des ersten Schaltmoduls (40a) und des zweiten Schaltmoduls (40b) eine jeweilige der beiden Einschaltschleifen (41) und eine jeweilige der beiden Ausschaltschleifen (42) umfasst;
das erste Antriebs-Eingangsende (VI1) des ersten Schaltmoduls (40a) mit dem ersten Antriebsmodul (20) verbunden ist und das zweite Antriebs-Eingangsende (VI2) des ersten Schaltmoduls (40a) mit dem zweiten Antriebsmodul (30) verbunden ist; und
das erste Antriebs-Eingangsende (VI1) des zweiten Schaltmoduls (40b) mit dem zweiten Antriebsmodul (30) verbunden ist und das zweite Antriebs-Eingangsende (VI2) des zweiten Schaltmoduls (40b) mit dem ersten Antriebsmodul (20) verbunden ist.

4. Antriebsvorrichtung nach Anspruch 1, wobei das erste Antriebsmodul (20) einen ersten Antriebstransformator (T1) umfasst, der eine erste Primärwicklung (T10) und mindestens eine erste Sekundärwicklung umfasst, wobei die erste Primärwicklung (T10) dazu konfiguriert ist, das erste Flankensteuerungssignal von dem Flankensteuerungs- und -erzeugungsmodul (10) zu empfangen, und jede der ersten Sekundärwicklungen dazu konfiguriert ist, ein erstes Flankenantriebssignal entsprechend dem ersten Flankensteuerungssignal auszugeben.

5. Antriebsvorrichtung nach Anspruch 4, wobei eine dritte Schaltröhre (S1) und eine dritte Diode (D1) zwischen dem Flankensteuerungs- und -erzeugungsmodul (10) und dem ersten Antriebstransformator (T1) angeordnet sind, die Gate-Elektrode der dritten Schaltröhre (S1) mit einem ersten Ausgangsende des Flankensteuerungs- und -erzeugungsmoduls (10) verbunden ist, die Anode der dritten Diode (D1) mit der Drain-Elektrode der dritten Schaltröhre (S1) verbunden ist und die Kathode der dritten Diode (D1) mit einem gepunkteten Ende der ersten Primärwicklung (T10) verbunden ist.

6. Antriebsvorrichtung nach Anspruch 5, wobei das Flankensteuerungs- und - erzeugungsmodul (10) einen Flankensteuerungs- und -erzeugungs-Chip und eine erste Schaltung zur Verbesserung der Antriebsfähigkeit umfasst;
wobei die erste Schaltung zur Verbesserung der Antriebsfähigkeit eine UND-Gate-Schaltung oder eine Gegentakt-Schaltung umfasst;
der Flankensteuerungs- und -erzeugungs-Chip dazu konfiguriert ist, das erste Flankensteuerungssignal an die erste Schaltung zur Verbesserung der Antriebsfähigkeit auszugeben; und
die erste Schaltung zur Verbesserung der Antriebsfähigkeit dazu konfiguriert ist, das erste Flankensteuerungssignal zu verarbeiten und das verarbeitete erste Flankensteuerungssignal an die Gate-Elektrode der dritten Schaltröhre (S1) auszugeben.

7. Antriebsvorrichtung nach Anspruch 1, wobei das zweite Antriebsmodul (30) einen zweiten Antriebstransformator (T2) umfasst, der eine zweite Primärwicklung (T20) und mindestens eine zweite Sekundärwicklung umfasst, wobei die zweite Primärwicklung (T20) dazu konfiguriert ist, das zweite Flankensteuerungssignal von dem Flankensteuerungs- und -erzeugungsmodul (10) zu empfangen, und jede der zweiten Sekundärwicklungen dazu konfiguriert ist, ein zweites Flankenantriebssignal entsprechend dem zweiten Flankensteuerungssignal auszugeben.

8. Antriebsvorrichtung nach Anspruch 7, wobei eine vierte Schaltröhre (S2) und eine vierte Diode (D2) zwischen dem Flankensteuerungs- und -erzeugungsmodul (10) und dem zweiten Antriebstransformator (T2) angeordnet sind, die Gate-Elektrode der vierten Schaltröhre (S2) mit einem zweiten Ausgangsende des Flankensteuerungs- und -erzeugungsmoduls (10) verbunden ist, die Anode der vierten Diode (D2) mit der Drain-Elektrode der vierten Schaltröhre (S2) verbunden ist und die Kathode der vierten Diode (D2) mit einem gepunkteten Ende der zweiten Primärwicklung (T20) verbunden ist.

9. Antriebsvorrichtung nach Anspruch 8, wobei das Flankensteuerungs- und - erzeugungsmodul (10) einen Flankensteuerungs- und -erzeugungs-Chip und eine zweite Schaltung zur Verbesserung der Antriebsfähigkeit umfasst;
wobei die zweite Schaltung zur Verbesserung der Antriebsfähigkeit eine UND-Gate-Schaltung oder eine Gegentakt-Schaltung umfasst;
der Flankensteuerungs- und -erzeugungs-Chip dazu konfiguriert ist, das zweite Flankensteuerungssignal an die zweite Schaltung zur Verbesserung der Antriebsfähigkeit auszugeben; und
die zweite Schaltung zur Verbesserung der Antriebsfähigkeit dazu konfiguriert ist,
das zweite Flankensteuerungssignal zu verarbeiten und das verarbeitete zweite Flankensteuerungssignal an die Gate-Elektrode der vierten Schaltröhre (S2) auszugeben.

10. Antriebsvorrichtung zum Antreiben einer Vielzahl von in Reihe geschalteten elektronischen Leistungsvorrichtungen, wobei die Antriebsvorrichtung umfasst:
ein Flankensteuerungs- und -erzeugungsmodul (10), das dazu konfiguriert ist, abwechselnd ein erstes Flankensteuerungssignal und ein zweites Flankensteuerungssignal auszugeben;
ein erstes Antriebsmodul (20), das dazu konfiguriert ist, das erste Flankensteuerungssignal zu empfangen und einen ersten Antriebstransformator (T1) umfasst, der eine erste Primärwicklung (T10) und N erste Sekundärwicklungen umfasst;
ein zweites Antriebsmodul (30), das dazu konfiguriert ist, das zweite Flankensteuerungssignal zu empfangen und einen zweiten Antriebstransformator (T2) umfasst, der eine zweite Primärwicklung (T20) und N zweite Sekundärwicklungen umfasst; und
eine Vielzahl von Schaltmodulen (40), die in einer Anzahl von N vorgesehen sind;
wobei jedes der Schaltmodule (40) eine Einschaltschleife (41), die mit einer jeweiligen der N ersten Sekundärwicklungen verbunden ist, und eine Ausschaltschleife (42) umfasst, die mit einer jeweiligen der N zweiten Sekundärwicklungen verbunden ist;
wobei die Einschaltschleife (41) eine erste Diode (D3) und ein erstes Antriebs-Eingangsende (VI1) umfasst, wobei eine Anode der ersten Diode (D3) mit dem ersten Antriebs-Eingangsende (VI1) verbunden ist und eine Kathode der ersten Diode (D3) mit einer Gate-Elektrode der elektronischen Leistungsvorrichtung (M1) verbunden ist;
wobei die Ausschaltschleife (42) eine erste Schaltröhre (S3), eine zweite Schaltröhre (S4) und ein zweites Antriebs-Eingangsende (VI2) umfasst; eine Gate-Elektrode der ersten Schaltröhre (S3) mit dem zweiten Antriebs-Eingangsende (VI2) verbunden ist; eine Drain-Elektrode der ersten Schaltröhre (S3) mit der Gate-Elektrode der zweiten Schaltröhre (S4) verbunden ist; die Source-Elektrode der zweiten Schaltröhre (S4) mit dem Gate der elektronischen Leistungsvorrichtung (M1) verbunden ist; und wobei die Drain-Elektrode der zweiten Schaltröhre (S4) mit einer Source-Elektrode der elektronischen Leistungsvorrichtung (M1) verbunden ist; und
wobei das erste Antriebs-Eingangsende (VI1) mit einer jeweiligen der N ersten Sekundärwicklungen verbunden ist und das zweite Antriebs-Eingangsende (VI2) mit einer jeweiligen der N zweiten Sekundärwicklungen verbunden ist;
wobei die Ausschaltschleife (42) ferner eine zweite Diode (D4) und eine RC-Schleife umfasst; die RC-Schleife zwischen der Drain-Elektrode und der Source-Elektrode der ersten Schaltröhre (S3) verbunden ist; die Anode der zweiten Diode (D4) mit dem ersten Antriebs-Eingangsende (VI1) verbunden ist und die Kathode der zweiten Diode (D4) mit der RC-Schleife verbunden ist;
wobei jede der elektronischen Leistungsvorrichtungen mit einem jeweiligen der Schaltmodule (40) verbunden ist.

11. Antriebsvorrichtung nach Anspruch 10, wobei eine dritte Schaltröhre (S1) und eine dritte Diode (D1) zwischen dem Flankensteuerungs- und -erzeugungsmodul (10) und dem ersten Antriebstransformator (T1) angeordnet sind, eine Gate-Elektrode der dritten Schaltröhre (S1) mit einem ersten Ausgangsende des Flankensteuerungs- und -erzeugungsmoduls (10) verbunden ist, eine Anode der dritten Diode (D1) mit einer Drain-Elektrode der dritten Schaltröhre (S1) verbunden ist und eine Kathode der dritten Diode (D1) mit einem gepunkteten Ende einer ersten Primärwicklung (T10) der ersten Sekundärwicklungen verbunden ist.

12. Antriebsvorrichtung nach Anspruch 11, wobei eine vierte Schaltröhre (S2) und eine vierte Diode (D2) zwischen dem Flankensteuerungs- und - erzeugungsmodul (10) und dem zweiten Antriebstransformator (T2) angeordnet sind, die Gate-Elektrode der vierten Schaltröhre (S2) mit einem zweiten Ausgangsende des Flankensteuerungs- und -erzeugungsmoduls (10) verbunden ist, die Anode der vierten Diode (D2) mit der Drain-Elektrode der vierten Schaltröhre (S2) verbunden ist und die Kathode der vierten Diode (D2) mit einem gepunkteten Ende einer zweiten Primärwicklung (T20) der zweiten Sekundärwicklungen verbunden ist.

13. Elektronisches Gerät, das die Antriebsvorrichtung nach einem der Ansprüche 1 bis 9 oder die Antriebsvorrichtung nach einem der Ansprüche 10 bis 12 umfasst.

## Revendications

1. Dispositif d'entraînement, comprenant,
un module de génération et de contrôle de bord (10), configuré pour délivrer alternativement un premier signal de contrôle de bord, et un deuxième signal de contrôle de bord ;
un premier module d'entraînement (20), configuré pour recevoir le premier signal de control de bord provenant du module de génération et de contrôle de bord (10) et pour émettre au moins un premier signal d'entraînement de bord selon le premier signal de contrôle de bord ;
un deuxième module d'entraînement (30), configuré pour recevoir le deuxième signal de contrôle de bord provenant du module de génération et de contrôle de bord (10) et émettre au moins un deuxième signal d'entraînement de bord selon le deuxième signal de contrôle de bord ; et
au moins un module de commutation (40), configuré pour recevoir le premier signal d'entraînement de bord provenant du premier module d'entraînement (20) et le deuxième signal d'entraînement de bord provenant du deuxième module d'entraînement (30), et pour allumer ou éteindre un dispositif électronique de puissance (M1) selon le premier signal d'entraînement de bord et le deuxième signal d'entraînement de bord ;
dans lequel au moins une boucle d'allumage (41) et au moins une boucle d'extinction (42) sont prévues, et chacun d'au moins un module de commutation (40) comprend une respective entre l'au moins une boucle d'allumage (41) et une respective entre une boucle respective de la l'au moins une boucle d'extinction (42) ;
la boucle d'allumage (41) comprend une première diode (D3) et une première extrémité d'entrée d'entraînement (VI1), une anode de la première diode (D3) est reliée à la première extrémité d'entrée d'entraînement (VI1), et une cathode de la première diode (D3) est reliée à une électrode de grille du dispositif électronique de puissance (M1) ;
la boucle d'extinction (42) comprend un premier tube de commutation (S3), un deuxième tube de commutation (S4) et une deuxième extrémité d'entrée d'entraînement (VI2) ; une électrode de grille du premier tube de commutation (S3) est reliée à la deuxième extrémité d'entrée d'entraînement (VI2) ; une électrode de drain du premier tube de commutation (S3) est reliée à l'électrode de grille du deuxième tube de commutation (S4) ; l'électrode de source du deuxième tube de commutation (S4) est reliée à la grille du dispositif électronique de puissance (M1) ;
et l'électrode de drain du deuxième tube de commutation (S4) est reliée à une électrode de source du dispositif électronique de puissance (M1) ; et
la première extrémité d'entrée d'entraînement (VI1) est configurée pour recevoir le premier signal d'entraînement de bord provenant du premier module d'entraînement (20), et la deuxième extrémité d'entrée d'entraînement (VI2) est configurée pour recevoir le deuxième signal d'entraînement de bord provenant du deuxième module d'entraînement (30) ; ou, la première extrémité d'entrée d'entraînement (VI1) est configurée pour recevoir le deuxième signal d'entraînement de bord provenant du deuxième module d'entraînement (30), et la deuxième extrémité d'entrée d'entraînement (VI2) est configurée pour recevoir le premier signal d'entraînement de bord provenant du premier module d'entraînement (20) ;
le dispositif d'entraînement étant **caractérisé en ce que**
la boucle d'extinction (42) comprend en outre une deuxième diode (D4) et une boucle RC ; la boucle RC est reliée entre l'électrode de drain et l'électrode de source du premier tube de commutation (S3) ; l'anode de la deuxième diode (D4) est reliée à la première extrémité d'entrée d'entraînement (VI1), et la cathode de la deuxième diode (D4) est reliée à la boucle RC.

2. Dispositif d'entraînement selon la revendication 1, dans lequel la boucle d'allumage (41) comprend en outre une première résistance (R2) reliée entre la cathode de la première diode (D3) et le dispositif électronique de puissance (M1) ; et
la boucle d'extinction (42) comprend en outre une deuxième résistance (R3) reliée entre une électrode source du deuxième tube de commutation (S4) et le dispositif électronique de puissance (M1).

3. Dispositif d'entraînement selon la revendication 1 ou 2, dans lequel l'au moins une boucle d'allumage (41) comprend deux boucles d'allumage (41), et l'au moins une boucle d'extinction (42) comprend deux boucles d'extinction (42) ; le module de commutation (40) comprend un premier module de commutation (40a) et un deuxième module de commutation (40b), et chacun du premier module de commutation (40a) et du deuxième module de commutation (40b) comprend une respective des deux boucles d'allumage (41) et une respective des deux boucles d'extinction (42) ;
la première extrémité d'entrée d'entraînement (VI1) du premier module de commutation (40a) est reliée au premier module d'entraînement (20), et la deuxième extrémité d'entrée d'entraînement (VI2) du premier module de commutation (40a) est reliée au deuxième module d'entraînement (30) ; et
la première extrémité d'entrée d'entraînement (VI1) du deuxième module de commutation (40b) est reliée au deuxième module d'entraînement (30), et la deuxième extrémité d'entrée d'entraînement (VI2) du deuxième module de commutation (40b) est reliée au premier module d'entraînement (20).

4. Dispositif d'entraînement selon la revendication 1, dans lequel le premier module d'entraînement (20) comprend un premier transformateur d'entraînement (T1) comprenant un premier enroulement primaire (T10) et au moins un premier enroulement secondaire, le premier enroulement primaire (T10) est configuré pour recevoir le premier signal de contrôle de bord provenant du module de génération et de contrôle de bord (10), et chacun des premiers enroulements secondaires est configuré pour émettre un premier signal d'entraînement de bord selon le premier signal de contrôle de bord.

5. Dispositif d'entraînement selon la revendication 4, dans lequel un troisième tube de commutation (S1) et une troisième diode (D1) sont disposés entre le module de génération et de contrôle de bord (10) et le premier transformateur d'entraînement (T1), l'électrode de grille du troisième tube de commutation (S1) est reliée à une première extrémité de sortie du module de génération et de contrôle de bord (10), l'anode de la troisième diode (D1) est reliée à l'électrode de drain du troisième tube de commutation (S1), et la cathode de la troisième diode (D1) est reliée à une extrémité marquée d'un point du premier enroulement primaire (T10).

6. Dispositif d'entraînement selon la revendication 5, dans lequel le module de génération et de contrôle de bord (10) comprend une puce de génération et de contrôle de bord et un premier circuit d'amélioration de la capacité d'entraînement
dans lequel le premier circuit d'amélioration de la capacité d'entraînement comprend un circuit de porte ET ou un circuit push-pull ;
la puce de génération et de contrôle de bord est configurée pour émettre le premier signal de contrôle de bord vers le premier circuit d'amélioration de la capacité d'entraînement ; et
le premier circuit d'amélioration de la capacité d'entraînement est configuré pour traiter le premier signal de contrôle de bord et pour émettre le premier signal de contrôle de bord traité vers l'électrode de grille du troisième tube de commutation (S1).

7. Dispositif d'entraînement selon la revendication 1, dans lequel le deuxième module d'entraînement (30) comprend un deuxième transformateur d'entraînement (T2) comprenant un deuxième enroulement primaire (T20) et au moins un deuxième enroulement secondaire, le deuxième enroulement primaire (T20) est configuré pour recevoir le deuxième signal de contrôle de bord provenant du module de génération et de contrôle de bord (10), et chacun des deuxièmes enroulements secondaires est configuré pour émettre un deuxième signal d'entraînement de bord selon le deuxième signal de control de bord.

8. Dispositif d'entraînement selon la revendication 7, dans lequel un quatrième tube de commutation (S2) et une quatrième diode (D2) sont disposés entre le module de génération et de contrôle de bord (10) et le deuxième transformateur d'entraînement (T2), l'électrode de grille du quatrième tube de commutation (S2) est reliée à une deuxième extrémité de sortie du module de génération et de contrôle de bord (10), l'anode de la quatrième diode (D2) est reliée à l'électrode de drain du quatrième tube de commutation (S2), et la cathode de la quatrième diode (D2) est reliée à une extrémité marquée d'un point du deuxième enroulement primaire (T20).

9. Dispositif d'entraînement selon la revendication 8, dans lequel le module de génération et de contrôle de bord (10) comprend une puce de génération et de contrôle de bord et un deuxième circuit d'amélioration de la capacité d'entraînement ;
dans lequel le deuxième circuit d'amélioration de la capacité d'entraînement comprend un circuit de porte ET ou un circuit push-pull ;
la puce de génération et de contrôle de bord est configurée pour émettre le deuxième signal de contrôle de bord vers le deuxième circuit d'amélioration de la capacité d'entraînement ; et
le deuxième circuit d'amélioration de la capacité d'entraînement est configuré pour traiter le deuxième signal de contrôle de bord et pour émettre le deuxième signal de contrôle de bord traité vers l'électrode de grille du quatrième tube de commutation (S2).

10. Dispositif d'entraînement, pour entraîner une pluralité de dispositifs électroniques de puissance reliés en série, le dispositif d'entraînement comprenant,
un module de génération et de contrôle de bord (10), configuré pour délivrer alternativement un premier signal de contrôle de bord, et un deuxième signal de contrôle de bord ;
un premier module d'entraînement (20) configuré pour recevoir le premier signal de contrôle de bord et comprenant un premier transformateur d'entraînement (T1) qui comprend un premier enroulement primaire (T10) et N premiers enroulements secondaires ;
un deuxième module d'entraînement (30) configuré pour recevoir le deuxième signal de contrôle de bord et comprenant un deuxième transformateur d'entraînement (T2) qui comprend un deuxième enroulement primaire (T20) et N deuxièmes enroulements secondaires ; et
une pluralité de modules de commutation (40) prévus dans un certain nombre de N ; dans lequel chacun des modules de commutation (40) comprend une boucle d'allumage (41) reliée à un respectif des N premiers enroulements secondaires, et une boucle d'extinction (42) reliée à un respectif des N deuxièmes enroulements secondaires ;
dans lequel la boucle d'allumage (41) comprend une première diode (D3) et une première extrémité d'entrée d'entraînement (VI1), une anode de la première diode (D3) étant reliée à la première extrémité d'entrée d'entraînement (VI1), et une cathode de la première diode (D3) étant reliée à une électrode de grille du dispositif électronique de puissance (M1) ;
dans lequel la boucle d'extinction (42) comprend un premier tube de commutation (S3), un deuxième tube de commutation (S4) et une deuxième extrémité d'entrée d'entraînement (VI2) ; une électrode de grille du premier tube de commutation (S3) étant reliée à la deuxième extrémité d'entrée d'entraînement (VI2) ; une électrode de drain du premier tube de commutation (S3) étant reliée à l'électrode de grille du deuxième tube de commutation (S4) ; l'électrode de source du deuxième tube de commutation (S4) étant reliée à la grille du dispositif électronique de puissance (M1) ; et l'électrode de drain du deuxième tube de commutation (S4) étant reliée à une électrode de source du dispositif électronique de puissance (M1) ; et
dans lequel la première extrémité d'entrée d'entraînement (VI1) est reliée à un respectif des N premiers enroulements secondaires et la deuxième extrémité d'entrée d'entraînement (VI2) est reliée à un respectif des N deuxièmes enroulements secondaires ;
dans lequel la boucle d'extinction (42) comprend en outre une deuxième diode (D4) et une boucle RC ; la boucle RC étant reliée entre l'électrode de drain et l'électrode de source du premier tube de commutation (S3) ; l'anode de la deuxième diode (D4) étant reliée à la première extrémité d'entrée d'entraînement (VI1), et la cathode de la deuxième diode (D4) étant reliée à la boucle RC ; dans lequel, chacun des dispositifs électroniques de puissance est relié à un respectif des modules de commutation (40).

11. Dispositif d'entraînement selon la revendication 10, dans lequel un troisième tube de commutation (S1) et une troisième diode (D1) sont disposés entre le module de génération et de contrôle de bord (10) et le premier transformateur d'entraînement (T1), une électrode de grille du troisième tube de commutation (S1) est reliée à une première extrémité de sortie du module de génération et de contrôle de bord (10), une anode de la troisième diode (D1) est reliée à une électrode de drain du troisième tube de commutation (S1), et une cathode de la troisième diode (D1) est reliée à une extrémité marquée d'un point d'un premier enroulement primaire (T10) des premiers enroulements primaires.

12. Dispositif d'entraînement selon la revendication 11, dans lequel un quatrième tube de commutation (S2) et une quatrième diode (D2) sont disposés entre le module de génération et de contrôle de bord (10) et le deuxième transformateur d'entraînement (T2), l'électrode de grille du quatrième tube de commutation (S2) est reliée à une deuxième extrémité de sortie du module de génération et de contrôle de bord (10), l'anode de la quatrième diode (D2) est reliée à l'électrode de drain du quatrième tube de commutation (S2), et la cathode de la quatrième diode (D2) est reliée à une extrémité marquée d'un point d'un deuxième enroulement primaire (T20) des deuxièmes enroulements primaires.

13. Appareil électronique comprenant le dispositif d'entraînement selon l'une quelconque des revendications 1 à 9, ou le dispositif d'entraînement selon l'une quelconque des revendications 10 à 12.
